# FASCICULE DE BREVET EUROPEEN

(11) **EP 0 607 075 B1**
(45) Date de publication et mention de la délivrance du brevet: **16.04.2003**
(21) Numéro de dépôt: 94400052.0
(22) Date de dépôt: 10.01.1994
(51) Int. Cl.: H01L 29/732, H01L 21/331, H01L 27/06, H01L 21/8249

(54) **Composant électronique semi-conducteur à résistance dynamique négative, méthodes d'utilisation et procédé de fabrication correspondants**
Elektronisches Halbleiterbauelement mit negativem dynamischem Widerstand und entsprechende Verwendungs- und Herstellungsverfahren
Semiconductor electronic component having a negative dynamic resistance and corresponding using methods and manufacturing process

(30) Priorité: 12.01.1993 FR 9300197
(43) Date de publication de la demande: 20.07.1994
(73) Titulaire: FRANCE TELECOM, 75015 Paris (FR)
(72) Inventeur: Skotnicki, Tomasz, F-38240 Meylan (FR); Merckel, Gérard, F-38330 Montbonnot (FR)
(74) Mandataire: Casalonga, Axel

(56) Documents cités:
- WO-A-91/07778
- FR-A- 2 586 862
- GB-A- 1 397 789
- US-A- 4 032 961
- US-A- 5 006 476
- IBM TECHNICAL DISCLOSURE BULLETIN, vol.20, no.8, Janvier 1978, NEW YORK US pages 3123 - 3124 C.G. JAMBOTKAR 'A LAMBDA DEVICE'
- PATENT ABSTRACTS OF JAPAN vol. 14, no. 205 (E-0921) 26 Avril 1990 & JP-A-02 044 758 (KOUDENSHI KOGYO KENKYUSHO K.K.) 14 Février 1990
- PATENT ABSTRACTS OF JAPAN vol. 7, no. 251 (E-209) (1396) 8 Novembre 1983 & JP-A-58 138 078 (MITSUBISHI DENKI K.K.) 16 Août 1983
- PATENT ABSTRACTS OF JAPAN vol. 10, no. 11 (E-374) (2068) 17 Janvier 1986 & JP-A-60 176 228 (TOSHIBA K.K.) 10 Septembre 1985
- IEEE TRANSACTIONS ON ELECTRON DEVICES, vol. 38, no. 6, Juin 1991, pages 1354-1361 (CHANTRE ET AL), IEEE, NEW YORK, US

## Description

L'invention concerne les composants semi-conducteurs capables de présenter une configuration de résistance dynamique négative.

De tels composants permettent notamment de réaliser des points de mémoires statiques de petites dimensions, aussi bien que des générateurs de signaux ou des circuits de régulation automatique ou de stabilisation d'un point de fonctionnement. Toutes ces fonctions trouvent en particulier leurs applications dans les circuits intégrés pour les systèmes de télécommunication.

On connaît, notamment par le brevet britannique n° 1 397 789, des composants électroniques capables de présenter une résistance dynamique négative, c'est-à-dire une configuration courant-tension dans laquelle le courant décroît lorsque la tension augmente. Cependant, de tels composants sont réalisés à partir d'éléments discrets et n'offrent pas par conséquent de structure intégrée.

Le brevet américain n° 4 032 961 décrit une structure intégrée capable de présenter une résistance dynamique négative. Cependant, dans une telle structure, le contact d'émetteur se situe sur le substrat ce qui la rend incompatible avec les technologies de fabrication BiCMOS (qui groupent sur la même pastille de silicium, des transistors à grille isolée à canal N et P (transistor CMOS), associés par exemple à un transistor bipolaire NPN) car, le substrat servirait alors d'émetteur commun pour tous les transistors fabriqués simultanément et ceux-ci ne seraient alors plus isolés les uns des autres.

De même, le brevet japonais JP-A-2 044 758 décrit un transistor bipolaire ayant une caractéristique de résistance négative. Toutefois, ce transistor n'est pas directement adaptable à une technologie de fabrication BICMOS.

On ne connaît pas actuellement de structure intégrée capable de présenter une résistance dynamique négative, et qui soit compatible avec une technologie de fabrication BiCMOS.

L'invention vise à remédier à cette lacune.

L'invention propose donc tout d'abord un composant électronique semi-conducteur selon la revendication 1. Des méthodes d'utilisation de ce composant sont décrites dans les revendications indépendants 15 et 16, un procédé de fabrication de ce composent étant décrit dans la revendication indépendante 17. Des réalisations particulières sont décrites dans les revendications dépendantes.

Il convient de remarquer-ici que l'invention apporte une solution au problème posé en proposant un composant électronique semi-conducteur, structurellement analogue en majeure partie, à un transistor bipolaire vertical, mais ne fonctionnant pas comme un transistor bipolaire sous l'application de ladite tension de polarisation.

Aussi, si l'on utilise néanmoins des termes caractérisant d'habitude la structure d'un transistor bipolaire, la première région active peut être dénommée par analogie "émetteur" ou "collecteur" , tandis que la deuxième région active peut être dénommée "base", et que la troisième région active peut être dénommée "collecteur" ou "émetteur".

La demande de brevet internationale WO 91/07 778 décrit un transistor bipolaire classique qui fonctionné effectivement comme un transistor bipolaire. Toutefois, contrairement à l'invention, ce transistor n'est pas susceptible de présenter une résistance dynamique négative sous l'influence d'une tension de polarisation de l'ordre de quelques volts et ne comprend ni une zone déplétable ni un moyen de déplétion pour dépléter la zone déplétable au moins sous l'influence d'une tension de polarisation de l'ordre de quelques volts.

D'autres avantages et caractéristiques de l'invention apparaîtront à l'examen de la description détaillée ci-après de modes de réalisation et de mise en oeuvre non limitatifs de l'invention, illustrés sur les dessins annexés sur lesquels :
- la figure 1 illustre schématiquement un premier mode de réalisation d'un composant électronique selon l'invention,
- la figure 2 illustre partiellement un deuxième mode de réalisation d'un composant selon l'invention,
- les figures 3a à 3s illustrent des étapes d'un procédé de fabrication selon l'invention,
- la figure 4 illustre une variante d'un tel procédé de fabrication, et
- la figure 5 illustre un autre mode de réalisation d'un composant électronique selon l'invention.

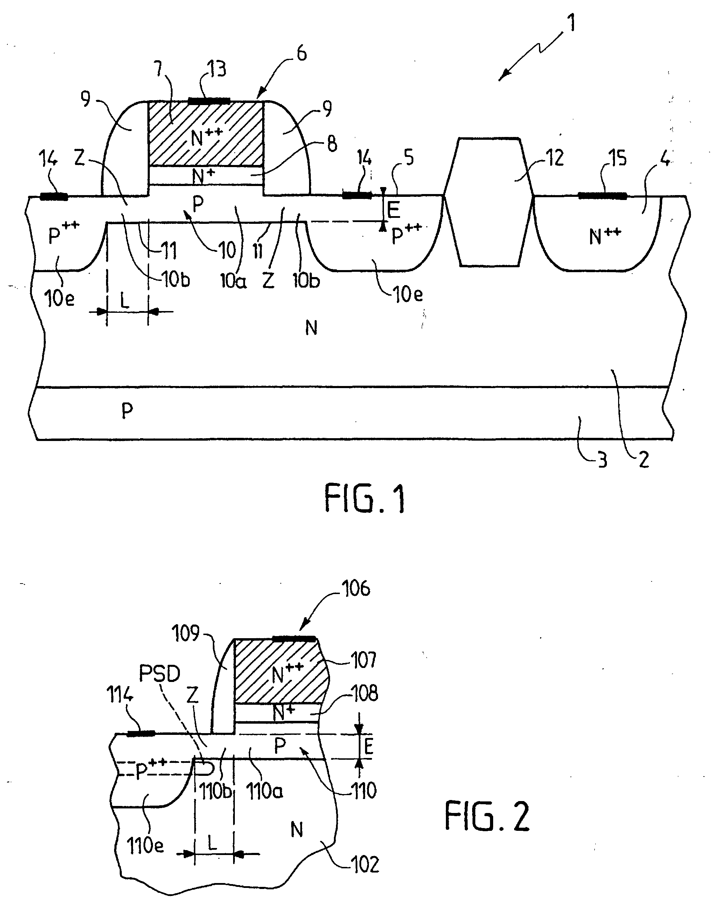

Tel qu'illustré sur la figure 1, le composant 1 est réalisé au sein d'une zone ou caisson semi-conducteur 2, ayant un premier type de conductivité, ici le type N (conduction par électrons), incorporé au sein d'un substrat semi-conducteur 3 ayant un deuxième type de conductivité, opposé au premier, ici le type P (conduction par trous). A droite (en regardant la figure 1) d'une région isolante 12, connue par l'homme du métier dans le domaine des semi-conducteurs sous la dénomination LOCOS, le caisson 2 incorpore une zone 4 surdopée N⁺⁺ sur laquelle se situe une métallisation 15. A titre indicatif, un surdopage du type N⁺⁺ (ou P⁺⁺) est équivalent à une concentration d'électrons (ou de trous) environ égale à 10²⁰cm⁻³ tandis que dans une région dopée N (ou P) la concentration d'électrons (ou de trous) est de l'ordre de 10¹⁷cm⁻³ ou moins.

A gauche de la région isolante 12, le composant 1 comporte une deuxième région 10 ayant le deuxième type de conductivité, ici le type P, s'étendant au sein du caisson N depuis la face supérieure 5 du substrat. Cette deuxième région 10 possède une partie centrale 10a ayant une concentration de dopage P, encadrée par une zone 10e surdopée P⁺⁺ sur laquelle est prévue une métallisation de contact 14.

Une région saillante 6 surmonte la face supérieure 5 du substrat (ou de la deuxième région 10) au-dessus de la partie centrale dopée P de la deuxième région. Cette région saillante 6 comporte dans sa partie centrale, une région 7, composée par exemple de polysilicium, ayant le premier type de conductivité, et surdopée N⁺⁺. Sous cette région 7 de polysilicium surdopé, se situe une couche 8 de silicium dopée N⁺ surmontant la partie centrale 10a de la région 10 dopée P. La région saillante 6 comporte également, de part et d'autre des régions 7 et 8, des régions latérales isolantes 9, ou espaceurs, composées par exemple de dioxyde de silicium SiO₂. Au sommet de cette région saillante 6 est prévue, au contact du silicium surdopé N⁺⁺, une métallisation de contact 13.

Sous les espaceurs 9, la deuxième région 10 présente une zone amincie par rapport à la partie centrale 10a située sous la couche 8 de silicium N⁺. Cette zone amincie 10b a une longucur L et une'épaisseur E. Elle a également par nature la même concentration de dopants que la partie centrale 10a. On verra ci-après que cette partie ou zone amincie 10b forme une zone déplétable Z susceptible d'être déplétée par des moyens de déplétion polarisables sous l'action d'une tension de polarisation de l'ordre de quelques volts. Ces moyens de déplétion sont ici formés par la jonction 11 entre le caisson N et la deuxième région 10.

On voit sur la figure 1 que la structure du composant électronique selon l'invention est en majeure partie analogue à une structure classique d'un transistor bipolaire vertical, telle que celle réalisée selon la technologie de fabrication BiCMOS. La différence structurelle avec un transistor bipolaire vertical réside ici dans la présence d'une zone déplétable ayant un dopage et des dimensions choisis, à la place d'une zone implantée dopée P⁺ par exemple, définissant un dopage non uniforme de la base extrinsèque connue par l'homme du métier sous la vocable LDEB (Lightly doped extrinsic base). Aussi, dans le composant électronique selon l'invention illustré sur la figure 1, la première région active définie ici par le caisson 2 et l'emplacement de contact 4 peut être par analogie désignée sous le vocable collecteur (le caisson N proprement dit définissant le collecteur intrinsèque tandis que la région surdopée 4 définit le collecteur extrinsèque). De même, la deuxième région 10 peut être considérée comme deuxième région active "de base", dans laquelle les régions surdopées 10e définissent la base extrinsèque. Enfin, la troisième région active, formée des régions 7 et 8 peut être assimilée à une région "d'émetteur" dans laquelle la région surdopée N⁺⁺ définit l'émetteur extrinsèque tandis que la région dopée N⁺ définit l'émetteur intrinsèque.

Dans la suite du texte, à des fins de simplification, on utilisera les termes émetteur, base et collecteur bien que ceux-ci comme expliqué ci-avant, ne soient pas réellement appropriés au composant selon l'invention dont le fonctionnement, comme le verra plus en détail ci-après, ne s'apparente pas à celui d'un transistor bipolaire.

La figure 2 illustre partiellement un autre mode de réalisation d'un composant selon l'invention. Sur cette figure, les éléments analogues ou ayant des fonctions analogues à ceux représentés à la figure 1, sont affectés de références augmentées de 100 par rapport à celles qu'ils avaient sur la figure 1. Seules les différences entre ces deux figures seront maintenant décrites.

Dans ce mode de réalisation de la figure 2, l'épaisseur des espaceurs 109, c'est-à-dire leur dimension prise à leur base reposant sur la face supérieure du substrat comptée parallèlement à la longueur L de la zone déplétable Z, est cette fois-ci inférieure à la longueur L de cette zone déplétable, alors que sur la figure 1, cette épaisseur était sensiblement égale à la longueur L. En d'autres termes, alors que sur la figure 1 les espaceurs surmontaient en totalité la partie amincie 10b formant la zone déplétable du composant, les espaceurs 109 surmontent seulement partiellement, dans la figure 2, la zone déplétable Z.

Lors de l'utilisation du composant selon l'invention, on applique, d'une façon générale, sur les métallisations des régions de base extrinsèque et d'émetteur des tensions fixes choisies pour polariser en direct la jonction émetteur-base, tandis l'on applique sur la métallisation du collecteur extrinsèque, une tension de polarisation variable qui va polariser en inverse la jonction collecteur-base pour dépléter la zone déplétable. La résistance dynamique négative sera alors obtenue à partir de la relation courant-tension collecteur.

Plus précisément, dans l'exemple décrit, où l'épaisseur E de la zone amincie 10b est de l'ordre de 0,15 µm, avec une concentration de dopants de l'ordre de 10¹⁷cm⁻³ et une longueur L de l'ordre de 0,5 µm, il s'est avéré possible de dépléter la région Z avec une polarisation collecteur positive de l'ordre de quelques volts en reliant l'émetteur à la masse et en appliquant une tension fixe sur la base de l'ordre de 0,5 volts. Lorsque la tension collecteur est nulle, le courant collecteur est négatif. Au début de l'augmentation de la tension collecteur, le courant collecteur diminue en valeur absolue jusqu'à atteindre la valeur nulle puis augmente en valeur absolue, car la jonction collecteur-base est de moins en moins polarisée en direct. Au fur et à mesure de l'augmentation de la tension collecteur, la différence de potentiel collecteur-base devient positive, ce qui polarise la jonction collecteur-base en inverse. Il en résulte une augmentation du courant collecteur qui cependant ne se stabilise pas en fonction de la tension collecteur, comme cela se produirait dans un transistor bipolaire, car l'augmentation de la tension collecteur provoque simultanément une expulsion, hors de la zone Z, des porteurs majoritaires (ici les trous) et donc une déplétion progressive de la zone Z par l'effet de champ de la jonction 11 et donc une modulation de la résistance d'accès de la base, et par conséquent, une coupure graduelle du passage du courant dans la base. Le courant collecteur décroît alors malgré l'augmentation de la tension de polarisation collecteur ce qui créé donc la caractéristique de résistance dynamique négative. Le courant collecteur recommencera à augmenter à partir d'un seuil de tension collecteur plus ou moins élevé, ce qui est dû soit un phénomène de perçage de la base soit un phénomène d'avalanche dans la jonction collecteur-base.

Un tel fonctionnement a été illustré pour une structure de composant que l'on pourrait assimiler structurellement à un transistor bipolaire vertical NPN. Bien entendu moyennant une inversion de tous les types de dopants, ce qui aboutirait à une structure de composant selon l'invention assimilable à un transistor PNP, les polarisations en direct de la jonction émetteur-base, et en inverse de la jonction collecteur-base seraient obtenues en inversant tous les signes des tensions appliquées sur les métallisations.

Dans les modes de réalisation des figures 1 et 2, tant l'épaisseur E que la concentration de dopants jouent un rôle essentiel dans le caractère déplétable de la zone Z. En effet, il convient que cette épaisseur E soit supérieure ou égale à une épaisseur-limite inférieure dont la valeur est reliée à la concentration de dopants de la zone déplétable. En effet, si cette épaisseur E est inférieure à l'épaisseur limite inférieure, la zone Z ne sera pas déplétable mais elle sera au contraire par nature déplétée d'elle-même en l'absence d'application d'une quelconque tension de polarisation sur le collecteur extrinsèque. Dans ce cas bien entendu, le composant selon l'invention ne pourra pas fonctionner et présenter une configuration de résistance dynamique négative.

De même, l'épaisseur E de cette zone déplétable doit rester inférieure ou égale à une épaisseur-limite supérieure, également reliée à la concentration de dopants, mais aussi à la valeur de la tension de polarisation que l'on souhaite appliquer pour dépléter la zone. En effet, si cette épaisseur E est supérieure à cette épaisseur limite supérieure, il sera difficile, voire impossible, de dépléter la zone Z, avec l'application de tensions de polarisation raisonnables, voire même avec l'application de tensions de polarisation élevées.

Concrètement, dans le cas d'une concentration de dopants de l'ordre de 10¹⁷cm⁻³ et aux fins d'utiliser des tensions de polarisation de l'ordre de quelques volts, par exemple inférieures à 5 volts, l'épaisseur limite inférieure peut être prise de l'ordre de 0,1 µm tandis que l'épaisseur limite supérieure peut avantageusement être ajustée de l'ordre de 0,2 µm. Néanmoins l'homme du métier comprendra que ces valeurs numériques doivent être prises à titre indicatif et peuvent être ajustées de façon plus précise pour chaque composé fabriqué en fonction notamment de son lot de fabrication, à partir de tests et/ou de simulation.

Par ailleurs, si la longueur L de la zone déplétable n'influe pas sur le caractère déplétable de cette zone, elle exerce une influence sur la chute du courant collecteur. En effet, si la longueur L de cette zone est insuffisante, des fuites importantes du courant de base peuvent apparaître, malgré une déplétion complète de la zone Z. Il est donc particulièrement avantageux d'ajuster la longueur L de cette zone de façon qu'elle soit au moins égale à une longueur limite inférieure qui a été prise dans ce cas de l'ordre de 0,3 µm.

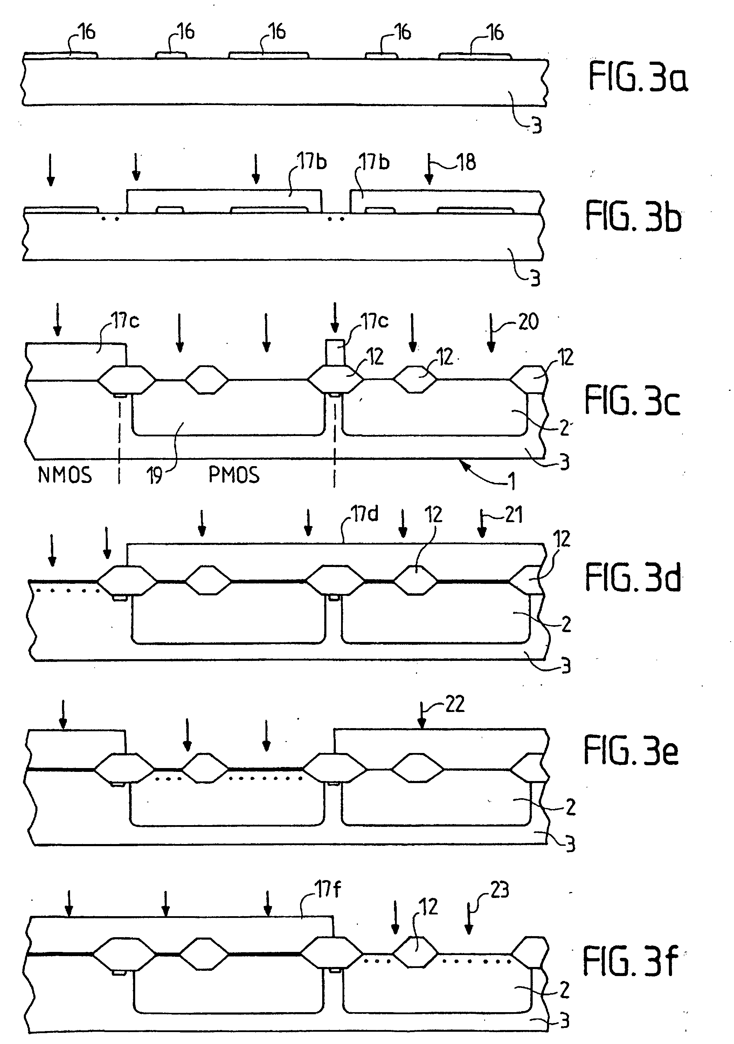

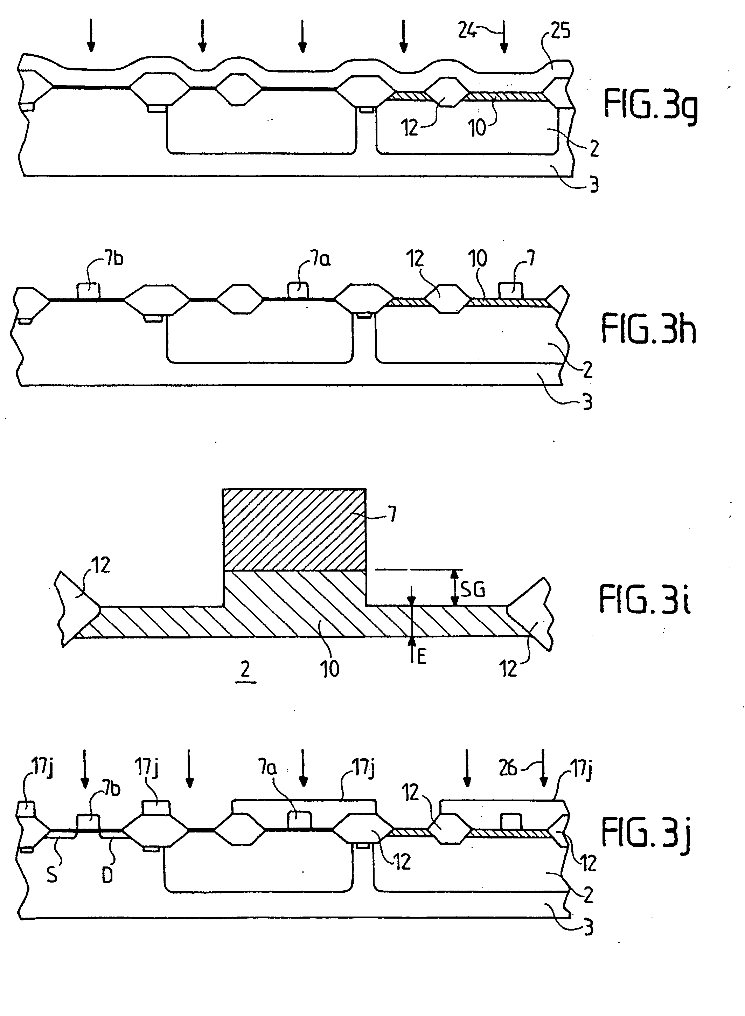

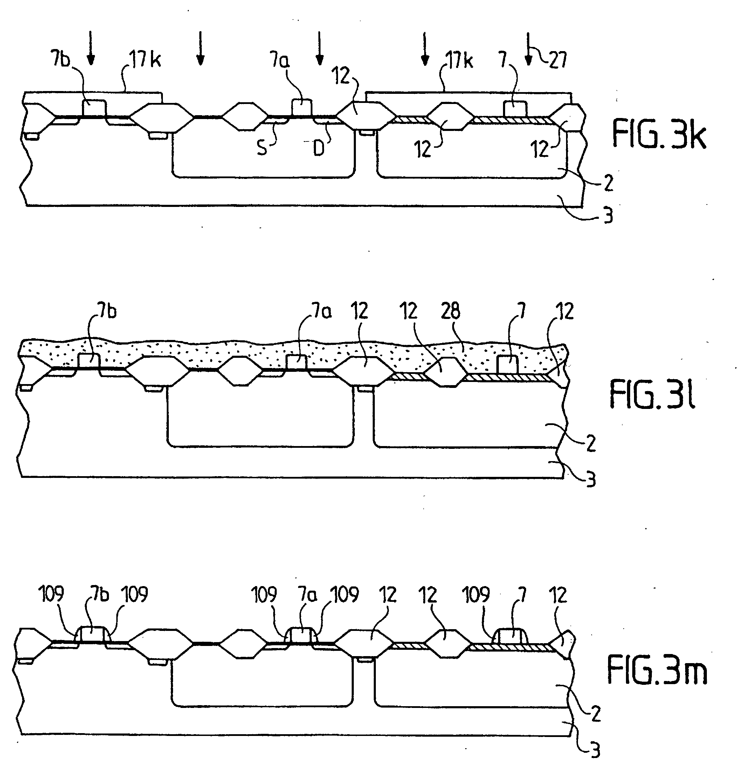

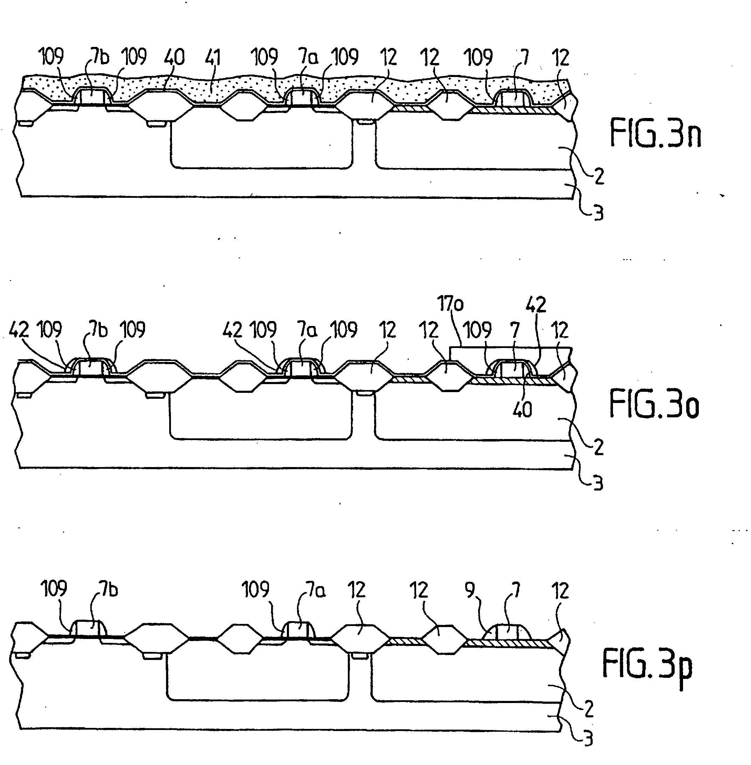

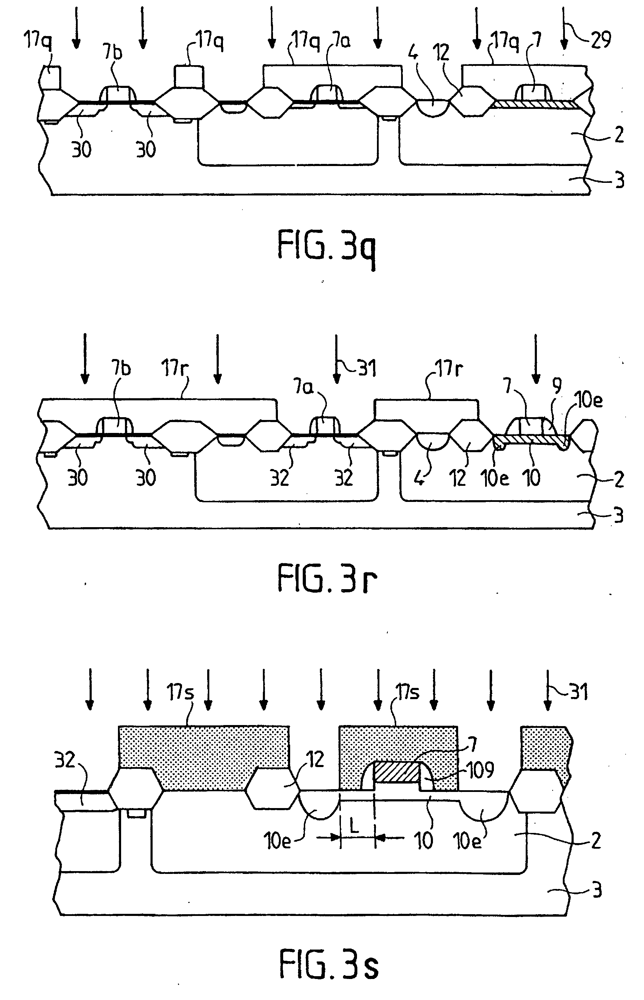

Un mode de mise en oeuvre d'un procédé de fabrication permettant notamment d'obtenir les réalisations illustrées sur les figures 1 et 2 va maintenant être décrit en référence aux figures 3a à 3s.

D'une façon générale, le procédé de fabrication selon l'invention comprend les étapes de :
- implantation, sous la face supérieure d'une première zone semi-conductrice ayant un premier type de conductivité (N par exemple), incorporée au sein d'un substrat semi-conducteur, d'une première couche semi-conductrice ayant un deuxième type de conductivité (par exemple P) opposé au premier,
- dépôt sur la face supérieure du substrat (ou de la première couche semi-conductrice), d'une deuxième couche d'un matériau semi-conducteur, suivi d'une implantation choisie de dopants pour conférer à cette deuxième couche le premier type de conductivité,
- gravure de cette deuxième couche dopée pour former une zone semi-conductrice saillante au-dessus du substrat, et surgravure de la première couche pour former au sein de cette première couche, de part et d'autre de la partie saillante ainsi formée sur le bloc semi-conducteur, une zone amincie ayant la même concentration de dopants que la partie de la première couche située sous la zone semi-conductrice saillante, et une épaisseur comprise entre une épaisseur limite inférieure et une épaisseur-limite supérieure reliées toutes les deux à ladite concentration de dopants,
- définition d'emplacement de contact sur la première zone semi-conductrice, la première couche semi-conductrice et la zone saillante semi-conductrice, et
- réalisation de métallisations sur les emplacements de contact.

Un tel procédé de fabrication est parfaitement compatible avec une technologie de fabrication du type BiCMOS ainsi qu'on va le voir maintenant.

Sur la figure 3a, la référence 3 désigne un substrat semi-conducteur de silicium dopé P, par exemple, au sein duquel vont être simultanément réalisés un transistor à effet de champ à grille isolée à canal N (NMOS), un transistor à effet de champ à grille isolée à canal P (PMOS), ces deux transistors formant un composé CMOS, ainsi que le composant électronique selon l'invention.

La première étape consiste alors à définir l'emplacement des zones actives des différents composants en déposant des couches de nitrure 16 sur la face supérieure du substrat 3.

Dans l'étape suivante (figure 3b) on effectue une implantation isobore 18 après avoir disposé des masques 17b sur les zones dans lesquelles seront réalisés le transistor PMOS et le composant à résistance dynamique négative. Cette implantation isobore permet notamment d'empêcher le phénomène d'inversion sous les régions isolantes (LOCOS) qui seront réalisées dans l'étape suivante au sein du substrat P.

Dans l'étape de la figure 3c, on procède, de façon connue, à une oxydation localisée de dioxyde de silicium de façon à former les régions isolantes 12 (LOCOS) puis on retire les couches de nitrure et l'on procède, après avoir placé un masque 17c sur la partie gauche du substrat (en regardant la figure) à une implantation 20 de phosphore ou d'arsenic par exemple de façon à former les caissons rétrogrades 2 et 19 au sein desquels seront respectivement réalisés le composant 1 selon l'invention et le transistor PMOS. Le transistor NMOS sera quant à lui réalisé dans la partie gauche du substrat. Un recuit après implantation est enfin réalisé.

Dans l'étape de la figure 3d, on procède, après avoir disposé un masque 17d au-dessus des caissons 2 et 19, à deux implantations 21 de bore afin notamment d'ajuster le seuil du transistor NMOS et de le protéger contre le phénomène connu de "perçage". Dans l'étape 3e, on ajuste par analogie le seuil du transistor PMOS en effectuant une implantation 22 de bore après avoir disposé des masques au-dessus du caisson 2 et de la zone du transistor NMOS.

Au cours de ces étapes, une mince couche d'oxyde a été déposée sur la face supérieure du substrat, y compris dans la région du composant à résistance négative, et qui constituera notamment les oxydes de grille des transistor à effet de champ.

On procède ensuite à un retrait de cette couche mince isolante au-dessus du caisson 2 et on effectue une implantation 23 de bore par exemple sur le bloc semi-conducteur muni d'un masque 17f recouvrant les zones des transistors à effet de champ. La région de base 10 du composant à résistance dynamique négative est ainsi formée.

Une couche 25 de polysilicium est ensuite déposée (figure 3g) sur la face supérieure du substrat avant de subir une implantation 24 d'arsenic par exemple pour lui conférer un dopage de type N⁺⁺. Après avoir effectué un recuit rapide il est procédé (figure 3h) à une gravure de cette couche de polysilicium dopé afin de définir respectivement les régions de grille 7a et 7b des transistors PMOS et NMOS et "d'émetteur" 7 du composant à résistance dynamique négative. En ce qui concerne les transistor NMOS et PMOS, la réalisation des régions de grille ne comporte qu'une gravure de la couche de polysilicium dopé car le subtrat reste isolé par une couche mince d'oxyde. Par contre, en ce qui concerne le composant à résistance dynamique négative, la gravure est prolongée par une légère surgravure SG du substrat, telle qu'illustrée sur la figure 3i, de façon à réaliser, de part et d'autre de la région saillante (émetteur) ainsi formée sur le bloc semi-conducteur, une zone amincie d'épaisseur E dont une partie formera la zone déplétable Z du composant à résistance dynamique négative.

L'étape illustrée sur la figure 3j consiste à réaliser les zones de source et de drain faiblement dopées LDD (Lightly Doped Drain) du transistor NMOS en effectuant une implantation 26 d'arsenic par exemple après avoir recouvert le bloc semi-conducteur par des masques 17j placés à des endroits choisis. Une telle implantation a également pour effet de réaliser le contact avec le caisson 19 du transistor PMOS et le contact avec le caisson 2 du composant à résistance dynamique négative.

On procède (figure 3k) à la réalisation des régions de source et de drain faiblement dopées LDD du transistor PMOS à partir d'une implantation de bore par exemple. Cette implantation nécessite au préalable d'avoir recouvert la zone du transistor NMOS et également la zone du composant à résistance négative d'un masque 17k afin de préserver une concentration de dopants uniforme dans la région de base (couche semi-conductrice 10) située sous la surface du caisson 2.

On dépose ensuite sur le bloc semi-conducteur ainsi formé (figure 31) une couche 28 d'oxyde de silicium par exemple, non dopé, et l'on procède, dans l'étape suivante illustrée sur la figure 3m, à la gravure des espaceurs associés à chacune des régions saillantes 7, 7a et 7b. Dans cette variante, tous les espaceurs 109 ont la même épaisseur alors que dans la variante illustrée sur la figure 3p, les espaceurs 9 associés au composant à résistance dynamique négative sont plus larges à leur base que les espaceurs 109 associés aux transistors à effet de champ NMOS et PMOS.

La réalisation des espaceurs élargis 9 est illustrée sur les figures 3n et 30. On dépose tout d'abord sur la surface supérieure du bloc semi-conducteur obtenu au stade illustré sur la figure 3m, une couche mince 40 de dioxyde de silicium. On dépose ensuite sur cette couche mince 40 une couche épaisse 41 de nitrure de silicium Si₃N₄. Il est ensuite procédé à une gravure partielle de la couche 41 pour réaliser des espaceurs 42 de Si₃N₄ reposant sur la couche mince 40 autour des espaceurs 109 de SiO₂. On dépose alors un masque 17o sur la partie du bloc semi-conducteur destinée à former le composant à résistance dynamique négative et l'on procède à une gravure chimique des espaceurs 42 des transistors NMOS et PMOS. Le masque 17o est ensuite enlevé et la mince couche 40 est retirée. On obtient alors la configuration illustrée sur la figure 3p, dans laquelle l'ensemble "espaceur 109 de SiO₂ - mince couche 40 de SiO₂ - espaceur 42 de Si₃N₄" forme les espaceurs élargis 9.

Il convient de remarquer que l'utilisation de deux isolants différents (dioxyde de silicium et nitrure de silicium) pour réaliser les espaceurs élargis permet d'effectuer une gravure chimique sélective. Par ailleurs, le dépôt préalable de la mince couche 40 de dioxyde de silicium permet ultérieurement de stopper la gravure chimique au niveau de cette mince couche de façon à ne pas attaquer la face supérieure du substrat (Si nu) ainsi que les espaceurs 109 en dioxyde de silicium.

Un tel procédé permet donc d'obtenir d'une façon simple et efficace des espaceurs d'épaisseurs différentes sur une même pastille de silicium.

On dispose ensuite (figure 3q) un masque 17q notamment au-dessus des régions saillantes du composant à résistance négative et du transistor PMOS et l'on procède à une implantation 29 d'arsenic de façon à réaliser les régions de source et de drain fortement dopées 30 du transistor NMOS. On rappelle ici que les zones de source et de drain possèdent alors un dopage N⁺ sous les espaceurs et un dopage N⁺⁺ entre la région N⁺ et les cloisons isolantes (LOCOS). Par cette implantation 29 on réalise également l'emplacement de contact 4, surdopé N⁺⁺, du composant à résistance dynamique négative et l'emplacement de contact avec le caisson du transistor PMOS.

Sur la figure 3r, est illustrée notamment la réalisation des zones 32 de drain et de source fortement dopées (PMOS), obtenues par une implantation 31 de bore après qu'un masque 17r ait été placé au-dessus de la zone du transistor NMOS, de l'emplacement de contact du caisson du transistor PMOS et de l'emplacement de contact 4 du composant à résistance dynamique négative. Cette implantation 31 a été également pour effet, puisque les espaceurs 9 du composant résistance dynamique négative forment masque, de réaliser les régions de "base extrinsèque" 10e, surdopées P⁺⁺, du composant à résistance dynamique négative. En d'autres termes, dans cette variante de mise en oeuvre, c'est l'épaisseur à la base des espaceurs qui détermine la longueur L de la zone déplétable du composant à résistance dynamique négative.

Dans le cas où le composant à résistance dynamique négative possède des espaceurs 109 ayant une épaisseur à leur base plus faible que la longueur L souhaitée pour la zone déplétable, il convient alors, comme illustré sur la figure 3s, de disposer au-dessus de la région saillante du composant à résistance dynamique négative, un masque 17s débordant de part et d'autre des espaceurs 109 d'une distance prédéterminée égale à la différence entre la longueur souhaitée L pour la zone déplétable et l'épaisseur des espaceurs comptée à leur base.

Les étapes finales du procédé de fabrication consistent notamment à graver les trous de contact puis à effectuer un recuit rapide final avant de procéder au dépôt d'une couche de silicide de métal ou de métal puis à une gravure et à un recuit des interconnexions ainsi formés.

Il est à noter que la région 8, dopée N⁺ dans la région saillante "d'émetteur" du composant selon l'invention (figure 1) est obtenue par diffusion des dopants à partir de la zone surdopée N⁺⁺, lors de recuits.

On obtient ainsi sur la même pastille de silicium le composant électronique à résistance dynamique négative selon l'invention, dans une variante analogue à celle illustrée sur la figure 1 (à la position près de la zone 4 surdopée et du LOCOS 12 qui résulte du choix particulier illustré sur les figures 3a à 3s) ou dans une variante analogue (à la même différence près) à celle illustrée sur la figure 2 selon la taille des espaceurs adoptés, ainsi que des transistors à effet de champ PMOS et NMOS. Un tel composant à résistance dynamique négative est par conséquent compatible avec une technologie de fabrication BiCMOS, le substrat ne servant pas d'émetteur commun. Par ailleurs, l'homme du métier aura remarqué que moyennant l'absence de la surgravure SG dans l'étape illustrée sur la figure 3i et moyennant le remplacement du masque 17k dans l'étape illustré sur la figure 3k par un masque recouvrant uniquement la zone du transistor NMOS, ainsi que la réalisation d'espaceurs 109 non élargis, on obtiendrait à la place du composant à résistance dynamique négative un transistor bipolaire vertical ayant une base extrinsèque à dopage non uniforme (LDEB).

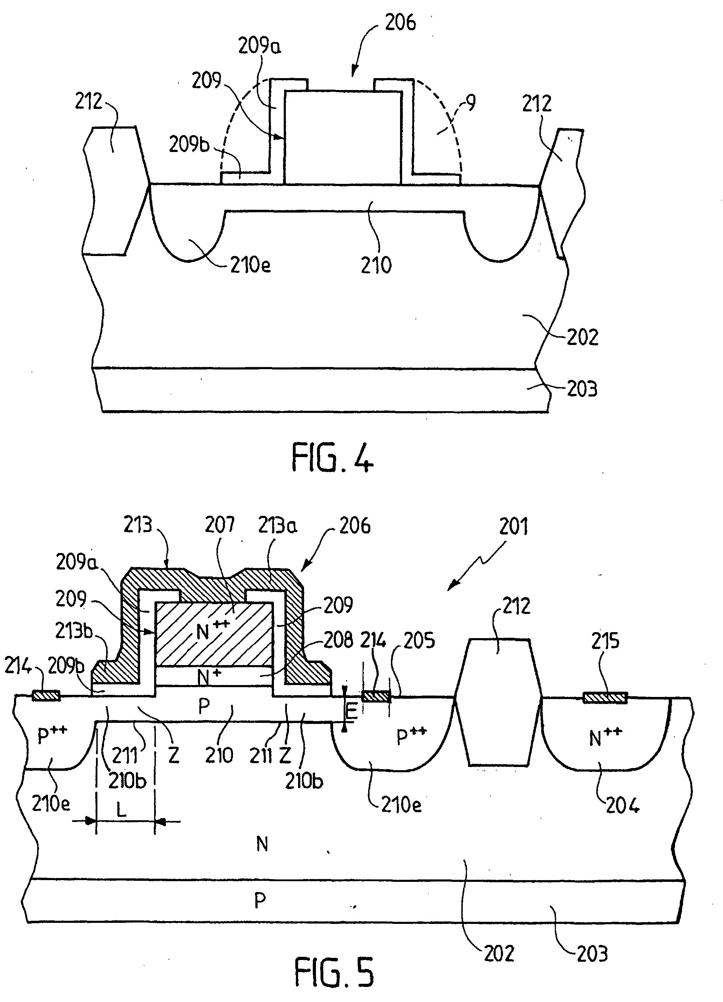

Dans le procédé de fabrication du composant à résistance dynamique négative, il est possible, après l'étape de réalisation des espaceurs 9 ou 109 et l'implantation des régions surdopées 10e, de retirer ces espaceurs pour déposer une mince couche isolante 209 (figure 4) d'une épaisseur de 15nm (150 Å) comportant une partie latérale verticale 209a située sur les bords latéraux de la région saillante 206, cette partie 209a étant prolongée sensiblement d'équerre par une partie horizontale 209b s'étendant sur la face supérieure du substrat au-dessus de la partie amincie qui formera la zone déplétable Z du composant à résistance dynamique négative. Lors de l'étape ultérieure de formation des métallisations, la métallisation disposée au contact de la région semi-conductrice active située dans la région saillante 206 incorporera une zone métallique disposée au-dessus de la partie 209b de la couche isolante.

On obtiendra alors en fin de fabrication, le mode de réalisation du composant à résistance dynamique négative illustré sur la figure 5.

Sur cette figure, les éléments analogues ou ayant des fonctions analogues à ceux représentés sur la figure 1 ont des références augmentées de 200 par rapport à celles qu'ils avaient sur la figure 1. Seules les différences entre ces deux figures seront décrites maintenant.

L'empilement zone métallique 213b - couche isolante 209b - zone semi-conductrice 210b - caisson 202, forme un transistor à effet de champ à grille isolée dont la partie semi-conductrice amincie 210b forme la région de canal. Dans cette variante d'exécution, les régions 207 et 208 forment cette fois-ci une région de "collecteur" tandis que les régions 204 et 202 forment respectivement les régions "d'émetteur extrinsèque" et "d'émetteur intrinsèque" et que la région 210 forme toujours une région de "base".

Lors de l'utilisation de ce composant, on applique sur les métallisations 215 et 214, des tensions choisies fixes (la métallisation 215 est par exemple reliée à la masse tandis que la métallisation 214 est reliée à une tension positive dans le cas présent, de 0,5 volt) pour polariser en direct la jonction première région active - deuxième région active (émetteur-base) tandis que l'on applique sur la métallisation de la troisième région active (collecteur) une tension de polarisation (croissant dans le cas présent depuis la valeur 0 volt jusqu'à la valeur de quelques volts) apte à dépléter le canal du transistor à effet de champ constitué, la configuration de résistance dynamique négative étant toujours prise au niveau du couple courant-tension collecteur.

Les modes de réalisation qui ont été décrits (figures 1 et 2, figure 5) utilisent des moyens de déplétion dictincts (effet de champ d'une jonction, effet de champ d'un transistor à effet de champ à grille isolée). On pourrait cependant envisager d'utiliser des moyens de déplétion utilisant à la fois l'effet de champ d'une jonction et l'effet de champ d'une grille isolée. A cet effet, on pourrait prévoir que la zone métallique située sur la couche isolante 209b soit indépendante de la métallisation 213 de la troisième région active. Dans ce cas, cette troisième région active formerait une région "d'émetteur"tandis que la deuxième région active formerait toujours la région de "base" et que la première région active formerait la région de "collecteur". On pourrait alors polariser de façon appropriée la zone métallique formant la grille du transistor à effet de champ dont le canal forme la zone déplétable. Par ailleurs, en appliquant également une tension de polarisation choisie et croissante sur la région de collecteur, les deux effets de champ provoqués d'une part par le transistor à effet de champ et d'autre part par la jonction collecteur-base contribueraient ensemble à dépléter la zone déplétable. Il serait ainsi possible soit d'obtenir une déplétion de la zone plus rapide avec une même tension collecteur de quelques volts ou bien encore d'obtenir une tene déplétion en étant moins exigeant sur les conditions de dimensionnement de la zone déplétable (épaisseur, longueur) et/ou sur la concentration de dopant.

Bien que décrit à base de silicium, le composant selon l'invention pourrait l'être à partir d'un autre matériau semi-conducteur. Par ailleurs, les métallisations ont été réalisées, dans tous les modes de réalisation décrits, sur des régions surdopées N⁺⁺ ou P⁺⁺. L'homme du métier sait que ceci est préférable dans le cas où le matériau semi-conducteur utilisé est du silicium. Néanmoins, il est possible de s'affranchir d'un tel surdopage de ces régions si l'on utilise un matériau semi-conducteur permettant d'obtenir directement un contact satisfaisant avec les métallisations. De tels matériaux existent parmi les matériaux III-V, c'est-à-dire des matériaux comportant à part égale un élément de la troisième colonne et une élément de la cinquième colonne de la classification périodique de Mendeléeff.

Bien que l'invention trouve ses pleins avantages dans les modes de réalisation ci-dessus décrits, il s'est avéré avantageux, dans certaines applications, de réaliser au sein de la première région active, une zone surdopée située sous la zone déplétable. Bien que cette variante de réalisation soit compatible avec tous les modes de réalisation ci-dessus décrits, la zone surdopée a été représentée uniquement sur la figure 2 et référencée PSD.

La présence d'une telle zone surdopée sous la zone déplétable permet, tout en réduisant la profondeur de la surgravure SG, de conduire à un zone déplétable amincie par un effet de réduction de la profondeur de la jonction et d'augmenter la concentration dans la partie caisson de la jonction et, ainsi, faciliter l'appauvrissement de la zone déplétable.

Par ailleurs, la réduction de la surgravure, c'est-à-dire l'augmentation de l'épaisseur E de la zone déplétable Z, permet de limiter les fuites de courant au niveau de l'angle formé à la limite de la zone déplétable Z et de la première partie 110a de la deuxième région active 110.

D'une façon générale, la réalisation de cette zone surdopée PSD située sous la zone amincie Z est obtenue par une implantation profonde de dopant ayant le même type de conductivité que le caisson, dans une partie du caisson située sous la zone amincie. Dans le cas où le caisson est de type N, on réalisera donc une implantation profonde d'arsenic à une dose et une énergie choisie de façon à atteindre le caisson au travers de la deuxième région active 110 de type P, sans toutefois modifier le type de conductivité de cette zone. On choisira par exemple une implantation d'arsenic à une dose de 2 10¹² par cm² de surface implantée, avec un pic de 10¹⁷m⁻³, sous une énergie de 500 keV.

Il est ainsi possible de diminuer la surgravure SG d'environ 20% par rapport à une variante de réalisation ne prévoyant pas cette implantation profonde de dopant.

Cette implantation profonde de dopant s'intègre parfaitement dans le procédé de réalisation qui a été décrit ci-dessus.

Ainsi, dans le cas où l'on prévoit des espaçeurs élargis, l'implantation d'arsenic s'effectuera après formation des premières régions latérales isolantes 109 (figure 3m) et avant la formation des régions latérales isolantes élargies 9 (figures 3n à 3p).

Dans le cas où l'on prévoit des espaceurs 109 ayant une largeur plus faible que la largeur L de la zone déplétable, l'implantation d'arsenic s'effectuera avantageusement avant la mise en place du masque 17s illustré sur la figure 3s.

Par ces deux modes de mise en oeuvre de l'implantation profonde d'arsenic, l'homme du métier remarquera que la zone surdopée du caisson située sous la zone déplétable s'étend alors à distance de la limite entre la zone déplétable et la première partie 110a de la deuxième région active 110 ce qui a pour effet de concentrer l'appauvrissement de la zone déplétable à distance du coin de l'espaceur, de façon à limiter encore les fuites potentielles.

Bien entendu, dans le cas où le caisson serait de type P, il conviendrait de remplacer l'implantation profonde d'arsenic par une implantation profonde de bore par exemple.

## Revendications

1. Composant électronique semi-conducteur comprenant au sein d'un substrat semi-conducteur (3) ayant une face supérieure, une première région active (2, 4; 202, 204) ayant un premier type de conductivité (N, N⁺⁺), et une deuxième région active (10; 210), ayant un deuxième type de conductivité (P, P⁺⁺), opposé au premier type, située entre la première région active (2; 202) et la face supérieure (5; 205) du substrat, et, sur la face supérieure du substrat, une région saillante (6; 206) contenant une troisième région active (7, 8; 207, 208) ayant le premier type de conductivité (N⁺, N⁺⁺) et surmontant une première partie (10a) de la deuxième région active, ainsi que des métallisations (13, 14, 15; 213, 214, 215)) respectivement situées au contact des trois régions actives (4, 10e, 7; 204, 210e, 207), dans lequel la deuxième région active comporte une zone semi-conductrice déplétable (Z) s'étendant à l'extérieur de la première partie (10a; 210a) de la deuxième région active, et entre la première région active (2; 202) et la face supérieure (5; 205) du substrat, la zone déplétable (Z) étant formée par une deuxième partie (10b; 210b) de la deuxième région active (10; 2b) amincie par rapport à la première partie (10a; 210a) de cette deuxième région active (10; 210) de telle sorte que de cette première partie (10a; 210a) s'etende dans le region saillante (6; 206) et possédant une concentration de dopants (P) sensiblement identique à celle de la première partie (10a) de la deuxième région active,
le composant comprenant en outre des moyens de déplétion (11; 213b, 209b, 211), situés au voisinage immédiat de cette zone déplétable (Z), et aptes à dépléter ladite zone déplétable sous l'action d'une tension de polarisation de l'ordre de quelques volts, de manière à ce que le composant présente une configuration de fonctionnement à résistance négative.

2. Composant selon la revendication 1, **caractérisé par le fait que** la zone déplétable (Z) possède une épaisseur (E) comprise entre une épaisseur-limite ayant inférieure et une épaisseur-limite supérieure ayant toutes deux des valeurs ajustées en fonction de la valeur de la concentration de dopants de facon à pemettre la déplétion de la zone déplétable.

3. Composant selon la revendication 2, **caractérisé par le fait que** la concentration de dopants est égale à 10¹⁷ cm⁻³ tandis que l'épaisseur (E) de la zone déplétable (Z) est égale à 0,15 µm.

4. Composant selon l'une des revendications 1 ou 2, **caractérisé par le fait que** la première région active (102) comporte, sous la zone déplétable (Z) une zone (PSD) surdopée par rapport au reste de la première region active (102).

5. Composant selon la revendication 4, **caractérisé par le fait que** la zone surdopée (PSD) est espacée de la limite entre la zone déplétable (Z) et la première partie (110a) de la deuxième région active (110).

6. Composant selon l'une des revendications 1 à 5, **caractérisé par le fait que** la longueur de la deuxième partie (10b) de la deuxième région active (10) est au moins égale à 0,3 µm.

7. Composant selon la revendication 6, **caractérisé par le fait que** la longueur de la deuxième partie (10b) de la deuxième région active est au moins égale à 0,5 µm.

8. Composant selon l'une des revendications précédentes, **caractérisé par le fait que** la région saillante (106) comporte des régions isolantes (109) de part et d'autre de la troisième région active (107) et surmontant partiellement la zone déplétable (Z).

9. Composant selon l'une des revendications 1 à 7, **caractérisé par le fait que** la région saillante (6; 206) comporte des régions isolantes (9; 209), situées de part et d'autre de la troisième région active (7; 207), et surmontant la totalité de la zone déplétable (Z).

10. Composant selon la revendication 9, **caractérisé par le fait que** les régions isolantes (9) comportent deux matériaux isolants différents (109, 42).

11. Composant selon l'une des revendications précédentes, **caractérisé par le fait que** les moyens de déplétion comportent la jonction (11;211) entre la première région active (2;202) et la deuxième partie (10b;210b) formant la zone déplétable.

12. Composant selon l'une des revendications précédentes, **caractérisé par le fait qu'**il comporte une zone métallique (213b) surmontant une couche isolante (209b) située sur la face supérieure du substrat au-dessus de la zone déplétable (Z), l'empilement zone métallique-couche isolante-zone déplétable-première région active formant un transistor à effet de champ à grille isolée dont la zone métallique forme la grille et dont la région de canal forme la zone déplétable.

13. Composant selon la revendication 12, **caractérisé par le fait que** les moyens de déplétion comportent la grille du transistor à effet de champ à grille isolée.

14. Composant selon les revendications 9 et 13 prises en combinaison, **caractérisé par le fait que** chaque région isolante comporte une portion (209a) située sur le bord latéral de la troisième région active, prolongée sensiblement d'équerre par une portion (209b) formant ladite couche isolante du transistor à effet de champ à grille isolée,
et **par le fait que** la métallisation située au contact de la troisième région active (207) incorpore ladite zone métallique (213b).

15. Méthode d'utilisation du composant selon l'une des revendications 1 à 13, dans laquelle on applique sur les métallisations des deuxième et troisième régions actives des tensions fixes, choisies de façon à polariser en direct la jonction troisième région active-deuxième région active, tandis que l'on applique sur la mécanisation de la première région active une tension de polarisation variable de l'ordre de quelques volts apte à polariser en inverse la jonction première région active-deuxième région active pour dépléter la zone déplétable, la résistance dynamique négative étant obtenue à partir de la relation courant tension prise au niveau de la première région active.

16. Méthode d'utilisation du composant selon la revendication 14, dans laquelle on applique sur les métallisations des première et deuxième régions actives des tensions fixes, choisies de façon à polariser en direct la jonction première région active-deuxième région active, tandis que l'on applique sur la métallisation de la troisième région active une tension de polarisation de l'ordre de quelques volts apte a dépléter le canal du transistor à effet de champ à grille isolée, la résistance dynamique négative étant obtenue à partir de la relation courant-tension prise au niveau de la troisième région active.

17. Procédé de fabrication du composant électronique semi-conducteur selon l'une des revendications 1 à 14, comprenant les étapes suivantes :
a) on implante (23), sous la face supérieure d'une première zone semi-conductrice (2) ayant un premier type de conductivité, incorporée au sein d'un substrat semi-conducteur (3), une première couche semi-conductrice (10) ayant un deuxième type de conductivité opposé au premier,
b) on dépose sur la face supérieure du substrat une deuxième couche (25) d'un matériau semi-conducteur, et on effectue une implantation de dopants au sein de cette deuxième couche pour lui conférer le premier type de conductivité,
c) on effectue une gravure de cette deuxième couche dopée pour former une zone semi-conductrice saillant au-dessus du substrat, ainsi qu'une surgravure (SG) de la première couche pour former au sein de ladite première couche, de part et d'autre de la partie saillante du bloc semi-conducteur ainsi formé, une zone amincie ayant sensiblement la même concentration de dopants que la partie de la première couche semi-conductrice située sous la zone semi-conductrice saillante, et une épaisseur (E) comprise entre une épaisseur limite inférieure et une épaisseur-limite supérieure, ayant toutes les deux des valeurs ajustées en fonction de ladite concentration de dopants de façon a permettre une déplétion de la zone amincie,
d) on définit des emplacements de contact sur la première zone semi-conductrice, la première couche conductrice et la zone saillante semi-conductrice, et
e) on effectue des métallisations sur les emplacements de contact.

18. Procédé selon la revendication 17, **caractérisé par le fait que** dans l'étape d), on dépose sur le substrat et la partie saillante, une première couche isolante, et on effectue une gravure de cette première couche isolante pour former de part et d'autre de la partie saillante, des régions latérales isolantes surmontant au moins partiellement la zone amincie de la première couche semi-conductrice, et on effectue de part et d'autre des régions latérales isolantes et à l'extérieur de la zone amincie, un surdopage de la première couche pour former une zone surdopée sur laquelle sera défini l'emplacement de contact correspondant, la distance séparant cette zone surdopée de la partie de la première couche semi-conductrice située sous la zone saillante semi-conductrice, définissant la longueur de la zone amincie.

19. Procédé selon la revendication 18, **caractérisé par le fait que** l'on définit la longueur de la zone amincie en gravant les régions latérales isolantes (9) pour leur conférer à leur base reposant sur le substrat une épaisseur sensiblement égale à ladite longueur, et **par le fait que** l'on effectue le surdopage de la première couche sur le bloc semi-conducteur ainsi formé, les régions latérales isolantes servant de masques.

20. Procédé selon la revendication 19, **caractérisé par le fait que** la gravure des régions latérales isolantes (9) comporte une gravure de ladite première couche isolante pour former des premières régions latérales isolantes (109) surmontant partiellement ladite zone amincie, puis un dépôt d'une mince couche isolante (40) sur la surface supérieure du bloc semi-conducteur ainsi formé, puis un dépôt d'une couche isolante supplémentaire (41) en un matériau isolant différent de celui formant la mince couche isolante (40) et les premières régions latérales (109), suivi d'une gravure de cette couche isolante supplémentaire pour former des deuxièmes régions latérales isolantes (42) couvrant les premières, les premières et deuxièmes régions latérales isolantes (109, 42) ainsi que la mince couche isolante (40) située entre elles formant lesdites régions latérales isolantes (9),
et **par le fait que** l'on retire ensuite la partie de la couche mince (40) située à l'extérieur des régions latérales isolantes (9).

21. Procédé selon la revendication 18, **caractérisé par le fait que** l'on grave les régions latérales isolantes (109) pour leur conférer une épaisseur à leur base reposant sur le substrat, inférieure à la longueur de la zone amincie, et **par le fait que** l'on dépose sur le bloc semi-conducteur ainsi formé, un masque débordant de part et d'autre des régions latérales isolantes d'une distance égale à la différence entre la longueur souhaitée pour la zone amincie et l'épaisseur des régions latérales isolantes, et l'on effectue le surdopage de la première couche semi-conductrice sur le bloc semi-conducteur muni de son masque débordant.

22. Procédé selon l'une des revendications 17 à 21, **caractérisé par le fait que** l'on réalise une implantation profonde de dopant ayant le même type de conductivité que la première zone semi-conductrice, dans une partie de celle-ci située sous la zone amincie pour former une zone (PSD) surdopée par rapport au reste de la première zone semi-conductrice située sous la zone amincie (Z).

23. Procédé selon les revendications 20 et 22 prises en combinaison, **caractérisé par le fait que** l'on réalise ladite implantation profonde de dopant après formation des premières régions latérales isolantes (109) et avant formation des régions latérales isolantes (9).

24. Procédé selon les revendications 21 et 22 prises en combinaison, **caractérisé par le fait que** l'on réalise ladite implantation profonde après la gravure des régions latérales isolantes (109).

25. Procédé selon l'une des revendications 18 à 24, **caractérisé par le fait que** l'on retire les régions latérales isolantes et l'on dépose une autre couche isolante comportant une partie (209a) située sur les bords latéraux de la partie saillante semi-conductrice, et une partie (209b) prolongeant d'équerre la partie latérale (209a) et surmontant la zone amincie de la première couche semi-conductrice, et, dans l'étape e), on prolonge la métallisation située sur la zone saillante semi-conductrice, par une zone métallique surmontant la partie (209) de la couche isolante située au-dessus de la zone amincie.

26. Procédé selon l'une des revendications 17 à 25, dans lequel le substrat incorpore à côté de la première zone semi-conductrice, une autre zone semi-conductrice (19) au sein de laquelle est réalisé simultanément un transistor à effet de champ à grille isolée, dont les régions actives de drain et de source présentent le deuxième type de conductivité et sont implantées selon deux implantations successives de dopants choisis, **caractérisé par le fait que** dans l'étape c), après surgravure de la première couche, on masque (17k) la face supérieure de la première couche semi-conductrice avant d'effectuer la première implantation des zones de drain et de source du transistor à effet de champ à grille isolée.

27. Procédé selon la revendication 26, **caractérisé par le fait que** la largeur des régions latérales isolantes du composant est sensiblement identique à la largeur des régions latérales isolantes du transistor à effet de champ à grille isolée.

## Patentansprüche

1. Elektronisches Halbleiterbauelement, umfassend in einem Halbleitersubstrat (3) mit einer Oberseite eine erste aktive Region (2, 4; 202, 204) mit einem ersten Konduktivitätstyp (N, N++) und eine zweite aktive Region (10; 210) mit einem zweiten Konduktivitätstyp (P, P++), der dem ersten Typ entgegengesetzt ist, angeordnet zwischen der ersten aktiven Region (2; 202) und der Oberseite (5; 205) des Substrats, und auf der Oberseite des Substrats eine vorspringende Region (6; 206), die eine dritte aktive Region (7, 8; 207, 208) mit dem ersten Konduktivitätstyp (N+, N++) enthält und über einem ersten Teil (10a) der zweiten aktiven Region angeordnet ist, sowie feste elektrische Verbindungen (13, 14, 15; 213, 214, 215), die jeweils mit den drei aktiven Regionen (4, 10e, 7; 204, 210e, 207) in Kontakt stehen, wobei die zweite aktive Region eine erschöpfbare Halbleiterzone (Z) umfasst, die sich außerhalb des ersten Teils (10a; 210a) der zweiten aktiven Region und zwischen der ersten aktiven Region (2; 202) und der Oberseite (5; 205) des Substrats erstreckt, wobei die erschöpfbare Zone (Z) von einem zweiten Teil (10b; 210b) der zweiten aktiven Region (10; 210) gebildet ist, der im Vergleich zum ersten Teil (10a; 210a) dieser zweiten aktiven Region (10; 210) dünner ist, so dass sich dieser erste Teil (10a,; 210a) in den vorspringenden Teil (6; 206) erstreckt, und der eine Konzentration an Dotiermitteln (P) aufweist, die im Wesentlichen gleich jener des ersten Teils (10a) der zweiten aktiven Region ist, wobei das Bauelement ferner Erschöpfungsmittel (11; 213b, 209b, 211) umfasst, die in unmittelbarer Nähe dieser erschöpfbaren Zone (Z) angeordnet und in der Lage sind, die erschöpfbare Zone unter der Wirkung einer Polarisationsspannung um ungefähr einige Volt zu erschöpfen, so dass das Bauelement eine Funktionsausführung mit negativem Widerstand aufweist.

2. Bauelement nach Anspruch 1, **dadurch gekennzeichnet, dass** die erschöpfbare Zone (Z) eine Dicke (E) zwischen einer unteren Grenzdicke und einer oberen Grenzdicke aufweist, die beide Werte aufweisen, die in Abhängigkeit von dem Wert der Konzentration der Dotiermittel angepasst sind, um die Erschöpfung der erschöpfbaren Zone zu ermöglichen.

3. Bauelement nach Anspruch 2, **dadurch gekennzeichnet, dass** die Konzentration an Dotiermitteln gleich 10¹⁷ cm⁻³ ist, während die Dicke (E) der erschöpfbaren Zone (Z) gleich 0,15 µm ist.

4. Bauelement nach einem der Ansprüche 1 oder 2, **dadurch gekennzeichnet, dass** die erste aktive Region (102) unter der erschöpfbaren Zone (Z) eine im Vergleich zum Rest der ersten aktiven Region (102) überdotierte Zone (PSD) umfasst.

5. Bauelement nach Anspruch 4, **dadurch gekennzeichnet, dass** die überdotierte Zone (PSD) von der Grenze zwischen der erschöpfbaren Zone (Z) und dem ersten Teil (110a) der zweiten aktiven Region (110) entfernt angeordnet ist.

6. Bauelement nach einem der Ansprüche 1 bis 5, **dadurch gekennzeichnet, dass** die Länge des zweiten Teils (10b) der zweiten aktiven Region (10) zumindest gleich 0,3 µm ist.

7. Bauelement nach Anspruch 6, **dadurch gekennzeichnet, dass** die Länge des zweiten Teils (10b) der zweiten aktiven Region zumindest gleich 0,5 µm ist.

8. Bauelement nach einem der vorhergehenden Ansprüche, **dadurch gekennzeichnet, dass** die vorspringende Region (106) isolierende Regionen (109) beiderseits der dritten aktiven Region (107) umfasst, die über der erschöpfbaren Zone (Z) angeordnet sind.

9. Bauelement nach einem der Ansprüche 1 bis 7, **dadurch gekennzeichnet, dass** die vorspringende Region (6; 206) isolierende Regionen (9; 209) umfasst, die beiderseits der dritten aktiven Region (7; 207) und über der gesamten erschöpfbaren Zone (Z) angeordnet sind.

10. Bauelement nach Anspruch 9, **dadurch gekennzeichnet, dass** die isolierenden Regionen (9) zwei unterschiedliche Isoliermaterialien (109, 42) umfassen.

11. Bauelement nach einem der vorhergehenden Ansprüche, **dadurch gekennzeichnet, dass** die Erschöpfungsmittel die Verbindung (11; 211) zwischen der ersten aktiven Region (2; 202) und dem zweiten Teil (10b; 210b), der die erschöpfbare Zone bildet, umfassen.

12. Bauelement nach einem der vorhergehenden Ansprüche, **dadurch gekennzeichnet, dass** es eine metallische Zone (213b) umfasst, die über einer Isolierschicht (209b) angeordnet ist, die sich auf der Oberseite des Substrats über der erschöpfbaren Zone (Z) befindet, wobei die Übereinanderlagerung der metallische Zone - Isolierschicht - erschöpfbare Zone - erste aktive Region einen Feldeffekttransistor mit isolierter Gate-Elektrode bildet, dessen metallische Zone die Gate-Elektrode und dessen Kanalzone die erschöpfbare Zone bildet.

13. Bauelement nach Anspruch 12, **dadurch gekennzeichnet, dass** die Erschöpfungsmittel die Gate-Elektrode des Feldeffekttransistors mit isolierter Gate-Elektrode umfassen.

14. Bauelement nach den Ansprüchen 9 und 13 in Kombination, **dadurch gekennzeichnet, dass** jede isolierende Region einen Abschnitt (209a) umfasst, der sich am seitlichen Rand der dritten aktiven Region befindet, die winkelrecht durch einen Abschnitt (209b) verlängert ist, der die Isolierschicht des Feldeffekttransistors mit isolierter Gate-Elektrode bildet, und dadurch, dass die feste elektrische Verbindung, die. mit der dritten aktiven Region (207) in Kontakt steht, die metallische Zone (213b) einschließt.

15. Einsatzmethode des Bauelements nach einem der Ansprüche 1 bis 13, bei der an die festen elektrischen Verbindungen der zweiten und dritten aktiven Region Spannungen angelegt werden, die derart ausgewählt werden, dass sie direkt die Verbindung dritte aktive Region - zweite aktive Region polarisieren, während an die feste elektrische Verbindung der ersten aktiven Region eine variable Polarisationsspannung von ungefähr einigen Volt angelegt wird, die in der Lage ist, die Verbindung erste aktive Region - zweite aktive Region umgekehrt zu polarisieren, um die erschöpfbare Zone zu erschöpfen, wobei der negative dynamische Widerstand aus dem Strom-Spannungs-Verhältnis erhalten wird, das auf Höhe der ersten aktiven Region entnommen wird.

16. Einsatzmethode des Bauelements nach Anspruch 14, bei der an die festen elektrischen Verbindungen der ersten und zweiten aktiven Region Spannungen angelegt werden, die derart ausgewählt werden, dass sie die Verbindung erste aktive Region - zweite aktive Region direkt polarisieren, während an die feste elektrische Verbindung der dritten aktiven Region eine Polarisationsspannung von ungefähr einigen Volt angelegt wird, die in der Lage ist, den Kanal des Feldeffekttransistors mit isolierter Gate-Elektrode zu erschöpfen, wobei der negative dynamische Widerstand aus dem Strom-Spannungs-Verhältnis, der auf Höhe der dritten aktiven Region entnommen wird, erhalten wird.

17. Verfahren zur Herstellung des elektronischen Halbleiterbauelements nach einem der Ansprüche 1 bis 14, umfassend die folgenden Schritte:
a) Einsetzen (23) unter die Oberseite einer ersten Halbleiterzone (2) mit einem ersten Konduktivitätstyp, die in ein Halbleitersubstrat (3) eingegliedert ist, einer ersten Halbleiterschicht (10) mit einem zweiten Konduktivitätstyp, der dem ersten entgegengesetzt ist;
b) Aufbringen auf die Oberseite des Substrats einer zweiten Schicht (25) eines Halbleitermaterials und Einbringen von Dotiermitteln in diese zweite Schicht, um ihr den ersten Konduktivitätstyp zu verleihen;
c) Gravur dieser zweiten dotierten Schicht, um eine Halbleiterzone zu bilden, die über dem Substrat vorspringt, sowie Übergravur (SG) der ersten Schicht, um in der ersten Schicht beiderseits des vorspringenden Teils des auf diese Weise gebildeten Halbleiterblocks eine dünnere Zone zu bilden, die im Wesentlichen dieselbe Konzentration an Dotiermitteln wie der Teil der ersten Halbleiterschicht aufweist, der sich unter der vorspringenden Halbleiterzone befindet, und eine Dicke (E) besitzt, die zwischen einer unteren Grenzdicke und einer oberen Grenzdicke liegt, wobei beide Werte aufweisen, die in Abhängigkeit von der Konzentration an Dotiermitteln angepasst sind, um eine Erschöpfung der dünneren Zone zu ermöglichen;
d) Definition der Kontaktstellen auf der ersten Halbleiterzone, der ersten leitenden Schicht und der vorspringenden Halbleiterzone, und
e) Ausführen der festen elektrischen Verbindungen an den Kontaktstellen.

18. Verfahren nach Anspruch 17, **dadurch gekennzeichnet, dass** in Schritt d) auf das Substrat und den vorspringenden Teil eine erste Isolierschicht aufgebracht und eine Gravur dieser ersten Isolierschicht durchgeführt wird, um beiderseits des vorspringenden Teils isolierende Seitenregionen zu bilden, die zumindest teilweise über der dünneren Zone der ersten Halbleiterschicht angeordnet sind, und dass beiderseits der isolierenden Seitenregionen und außerhalb der dünneren Zone eine Überdotierung der ersten Schicht erfolgt, um eine überdotierte Zone zu bilden, auf der die entsprechende Kontaktstelle definiert wird, wobei der Abstand zwischen dieser überdotierten Zone und dem Teil der ersten Halbleiterschicht, die sich unter der vorspringenden Halbleiterzone befindet, die Länge der dünneren Zone definiert.

19. Verfahren nach Anspruch 18, **dadurch gekennzeichnet, dass** die Länge der dünneren Zone definiert wird, indem die isolierenden Seitenregionen (9) graviert werden, um ihnen an ihrer Basis, die auf dem Substrat liegt, eine im Wesentlichen gleiche Dicke wie die Länge zu verleihen, und dadurch, dass die Überdotierung der ersten Schicht auf dem auf diese Weise gebildeten Halbleiterblock durchgeführt wird, wobei die isolierenden Seitenregionen als Masken dienen.

20. Verfahren nach Anspruch 19, **dadurch gekennzeichnet, dass** die Gravur der isolierenden Seitenregionen (9) eine Gravur der ersten Isolierschicht, um erste isolierende Seitenregionen (109) zu bilden, die teilweise über der dünneren Zone angeordnet sind, sodann ein Aufbringen einer dünnen Isolierschicht (40) auf die Oberfläche des auf diese Weise gebildeten Halbleiterblocks, sodann ein Aufbringen einer zusätzlichen Isolierschicht (41) aus einem anderen Isoliermaterial als jenes, das die dünne Isolierschicht (40) und die ersten Seitenregionen (109) bildet, umfasst, gefolgt von einer Gravur dieser zusätzlichen Isolierschicht, um zweite isolierende Seitenregionen (42) zu bilden, die die ersten abdecken, wobei die ersten und zweiten isolierenden Seitenregionen (109, 42) sowie die zwischen ihnen befindliche dünne Isolierschicht (40) die isolierenden Seitenregionen (9) bilden, und dadurch, dass sodann der Teil der dünnen Schicht (40), der sich außerhalb der isolierenden Seitenregionen (9) befindet, weggenommen wird.

21. Verfahren nach Anspruch 18, **dadurch gekennzeichnet, dass** die isolierenden Seitenregionen (109) graviert werden, um ihnen eine Dicke an ihrer auf dem Substrat liegenden Basis zu verleihen, die kleiner als die Länge der dünneren Zone ist, und dadurch, dass auf den auf diese Weise gebildeten Halbleiterblock eine Maske aufgebracht wird, die beiderseits der isolierenden Seitenregionen um einen Abstand gleich dem Unterschied zwischen der gewünschten Länge für die dünnere Zone und der Dicke der isolierenden Seitenregionen vorsteht, und die Überdotierung der ersten Halbleiterschicht auf dem Halbleiterblock erfolgt, der mit seiner vorstehenden Maske versehen ist.

22. Verfahren nach einem der Ansprüche 17 bis 21, **dadurch gekennzeichnet, dass** ein tiefes Einsetzen von Dotiermittein mit demselben Konduktivitätstyp wie die erste Halbleiterzone in einen Teil derselben erfolgt, der sich unter der dünneren Zone befindet, um eine überdotierte Zone (PSD) in Bezug auf die restliche erste Halbleiterzone zu bilden, die sich unter der dünneren Zone (Z) befindet.

23. Verfahren nach den Ansprüchen 20 und 22 in Kombination, **dadurch gekennzeichnet, dass** dieses tiefe Einsetzen von Dotiermitteln nach Bildung der ersten isolierenden Seitenregionen (109) und vor Bildung der isolierenden Seitenregionen (9) erfolgt.

24. Verfahren nach den Ansprüchen 21 und 22 in Kombination, **dadurch gekennzeichnet, dass** dieses tiefe Einsetzen nach der Gravur der isolierenden Seitenregionen (109) erfolgt.

25. Verfahren nach einem der Ansprüche 18 bis 24, **dadurch gekennzeichnet, dass** die isolierenden Seitenregionen weggenommen werden und eine weitere Isolierschicht aufgebracht wird, die einen Teil (209a), der sich an den Seitenrändern des vorspringenden Halbleiterteils befindet, und einen Teil (209b) umfasst, der winkelrecht den Seitenteil (209a) verlängert und über der dünneren Zone der ersten Halbleiterschicht angeordnet ist, und dass in Schritt e) die feste elektrische Verbindung, die sich auf der vorspringenden Halbleiterzone befindet, durch eine metallische Zone verlängert ist, die über dem Teil (209) der Isolierschicht angeordnet ist, die sich über der dünneren Zone befindet.

26. Verfahren nach einem der Ansprüche 17 bis 25, bei dem das Substrat neben der ersten Halbleiterzone eine weitere Halbleiterzone (19) umfasst, in der gleichzeitig ein Feldeffekttransistor mit isolierter Gate-Elektrode ausgeführt ist, dessen aktive Drainund Quellenregionen den zweiten Konduktivitätstyp aufweisen und nach zwei aufeinander folgenden Einbringungen von ausgewählten Dotiermitteln eingesetzt sind, **dadurch gekennzeichnet, dass** in Schritt c) nach der Übergravur der ersten Schicht die Oberseite der ersten Halbleiterschicht maskiert (17k) wird, bevor das erste Einsetzen der Drain- und Quellenzonen des Feldeffekttransistors mit isolierter Gate-Elektrode erfolgt.

27. Verfahren nach Anspruch 26, **dadurch gekennzeichnet, dass** die Breite der isolierenden Seitenregionen des Bauelements im Wesentlichen identisch mit der Breite der isolierenden Seitenregionen des Feldeffekttransistors mit isolierter Gate-Elektrode ist.

## Claims

1. Electronic semiconductor component comprising, within a semiconductor substrate (3) having an upper face, a first active region (2, 4; 202, 204) having a first type of conductivity (n n⁺⁺), and a second active region (10; 210), having a second type of conductivity (p, p), the opposite of the first type, located between the first active region (2; 202) and the upper face (5; 205) of the substrate, and, on the upper face of the substrate, a projecting region (6; 206) containing a third active region (7, 8; 207, 208) having the first type of conductivity (n⁺, n⁺⁺) and surmounting a first part (10a) of the second active region, together with metallizations (13, 14, 15; 213, 214, 215) respectively situated in contact with the three active regions (4, 10e, 7; 204, 210e, 207),
in which the second active region comprises a depletable semiconductor zone (Z) lying outside the first part (10a; 210a) of the second active region, and between the first active region (2; 202) and the upper face (5; 205) of the substrate, the depletable zone (Z) being formed by a second part (10b; 210b) of the second active region (10; 210) thinned with respect to the first part (10a; 210a) of this second active region (10; 210) such that this first part (10a; 210a) lies in the projecting region (6; 206) and having a concentration of dopants (p) substantially identical to that of the first part (10a) of the second active region,
the component further comprising depletion means (11; 213b, 209b, 211), located in the immediate vicinity of this depletable zone (Z) and capable of depleting the said depletable zone under the effect of a bias voltage of the order of a few volts, so that the component has an operating configuration with a negative resistance.

2. Component according to Claim 1, **characterized in that** the depletable zone (Z) has a thickness (E) between a lower-limit thickness and an upper-limit thickness, both having values adjusted as a function of the dopant concentration value so as to allow the depletion of the depletable zone.

3. Component according to Claim 2, **characterized in that** the dopant concentration is equal to 10¹⁷cm⁻³ while the thickness (E) of the depletable zone (Z) is equal to 0.15 µm.

4. Component according to either of Claims 1 or 2, **characterized in that** the first active region (102) comprises, under the depletable zone (Z), a zone (PSD) which is overdoped with respect to the rest of the first active region (102).

5. Component according to Claim 4, **characterized in that** the overdoped zone (PSD) is spaced over the boundary between the depletable zone (Z) and the first part (110a) of the second active region (110).

6. Component according to one of Claims 1 to 5, **characterized in that** the length of the second part (10b) of the second active region (10) is at least equal to 0.3 µm.

7. Component according to Claim 6, **characterized in that** the length of the second part (10b) of the second active region is at least equal to 0.5 µm.

8. Component according to one of the preceding claims, **characterized in that** the projecting region (106) comprises isolating regions (109) on either side of the third active region (107) and partially surmounting the depletable zone (Z).

9. Component according to one of Claims 1 to 7, **characterized in that** the projecting region (6; 206) comprises isolating regions (9; 209), located on either side of the third active region (7; 207), and surmounting the entire depletable zone (Z).

10. Component according to Claim 9, **characterized in that** the isolating regions (9) comprise two different isolating materials (109, 42).

11. Component according to one of the preceding claims, **characterized in that** the depletion means comprise the junction (11; 211) between the first active region (2; 202) and the second part (10b; 210b) forming the depletable zone.

12. Component according to one of the preceding claims, **characterized in that** it comprises a metallic zone (213b) surmounting an isolating layer (209b) located on the upper face of the substrate above the depletable zone (Z), the metallic zone - isolating layer - depletable zone - first active region stack forming an isolated gate field effect transistor, the metallic zone of which forms the gate and the channel region of which forms the depletable zone.

13. Component according to Claim 12, **characterized in that** the depletion means form the gate of the isolated gate field effect transistor.

14. Component according to Claims 9 and 13 taken together, **characterized in that** each isolating region comprises a portion (209a) located on the side edge of the third active region, extended substantially at right angles by a portion (209b) forming the said isolating layer of the isolated gate field effect transistor,
and **in that** the metallization located in contact with the third active region (207) includes the said metallic zone (213b).

15. Method of using the component according to one of Claims 1 to 13, in which fixed voltages, chosen so as to forward bias the third active region-second active region junction, are applied to the metallizations of the second and third active regions while a variable bias voltage of the order of a few volts and capable of reverse biasing the first active region-second active region junction is applied to the metallization of the first active region in order to deplete the depletable zone, the negative dynamic resistance being obtained from the current-voltage equation taken at the first active region.

16. Method of using the component according to Claim 14, in which fixed voltages, chosen so as to forward bias the first active region-second active region junction, are applied to the metallizations of the first and second active regions while a bias voltage of the order of a few volts and capable of depleting the channel of the isolated gate field effect transistor is applied to the metallization of the third active region, the negative dynamic resistance being obtained from the current-voltage equation taken at the third active region.

17. Method of fabricating the electronic semiconductor component according to one of Claims 1 to 14, comprising the following steps:
a) under the upper face of a first semiconductor zone (2) having a first type of conductivity, incorporated within a semiconductor substrate (3), is implanted (23) a first semiconductor layer (10) having a second type of conductivity the opposite of the first,
b) a second layer (25) of a semiconductor is deposited on the upper face of the substrate and dopants are implanted within this second layer in order to give it the first type of conductivity,
c) this second doped layer is etched in order to form a semiconductor zone projecting above the substrate, together with overetching (SG) of the first layer in order to form, within the said first layer, on either side of the part projecting from the semiconductor block thus formed, a thinned zone having substantially the same dopant concentration as the part of the first semiconductor layer located under the projecting semiconductor zone, and a thickness (E) between a lower-limit thickness and an upper-limit thickness, both having values adjusted as a function of the said dopant concentration so as to allow depletion of the thinned zone,
d) contact points are defined on the first semiconductor zone, the first conducting layer and the projecting semiconductor zone, and
e) metallizations are produced on the contact points.

18. Method according to Claim 17, **characterized in that**, in step d), a first isolating layer is deposited on the substrate and the projecting part, and this first isolating layer is etched in order to form on either side of the projecting part, isolating lateral regions surmounting, at least partially, the thinned zone of the first semiconductor layer, and the first layer is overdoped on either side of the isolating lateral regions and outside the thinned zone in order to form an overdoped zone on which the corresponding contact point will be defined, the distance separating this overdoped zone from the part of the first semiconductor layer located under the projecting semiconductor zone, defining the length of the thinned zone.

19. Method according to Claim 18, **characterized in that** the length of the thinned zone is defined by etching the isolating lateral regions (9) in order to give them, at their base resting on the substrate, a thickness substantially equal to the said length, and **in that** the first layer on the semiconductor block thus formed is overdoped, the isolating lateral regions acting as masks.

20. Method according to Claim 19, **characterized in that** the etching of the isolating lateral regions (9) comprises etching of the said first isolating layer in order to form first isolating lateral regions (109) partially surmounting the said thinned zone, then deposition of a thin isolating layer (40) on the upper surface of the semiconductor block thus formed, then deposition of an additional isolating layer (41) made of an isolating material different from that forming the thin isolating layer (40) and the first lateral regions (109), followed by etching of this additional isolating layer in order to form second isolating lateral regions (42) covering the first, the first and second isolating lateral regions (109, 42) together with the thin isolating layer (40) located between them forming the said isolating lateral regions (9), and **in that** the part of the thin layer (40) located outside the isolating lateral regions (9) is then removed.

21. Method according to Claim 18, **characterized in that** the isolating lateral regions (109) are etched in order to give them a thickness, at their base resting on the substrate, less than the length of the thinned zone, and **in that** a mask protruding on either side of the isolating lateral regions by a distance equal to the difference between the length desired for the thin zone and the thickness of the lateral isolating regions is deposited on the semiconductor block thus formed, and the first semiconductor layer on the semiconductor block fitted with its protruding mask is overdoped.

22. Method according to one of Claims 17 to 21, **characterized in that** a deep implantation of dopant having the same type of conductivity as the first semiconductor zone is carried out in a part thereof located under the thinned zone in order to form a zone (PSD) which is overdoped with respect to the rest of the first semiconductor zone and located under the thinned zone (Z).

23. Method according to Claims 20 and 22 taken in combination, **characterized in that** said deep implantation of dopant is carried out after formation of the first isolating lateral regions (109) and before formation of the isolating lateral regions (9).

24. Method according to Claims 21 and 22 taken in combination, **characterized in that** the said deep implantation is carried out after etching of the isolating lateral regions (109).

25. Method according to one of Claims 18 to 24, **characterized in that** the isolating lateral regions are removed and another isolating layer comprising a part (209a) located on the side edges of the projecting semiconductor part and a part (209b) extending the side parts (209a) at right angles and surmounting the thinned zone of the first semiconductor layer are deposited, and, in step e), the metallization located over the projecting semiconductor zone is extended by a metallic zone surmounting the part (209) of the isolating layer located above the thinned zone.

26. Method according to one of Claims 17 to 25, in which the substrate incorporates, at the side of the first semiconductor zone, another semiconductor zone (19) within which an isolated gate field effect transistor is made simultaneously, the active drain and source regions of which have the second type of conductivity and are implanted according to two successive implantations of chosen dopants, **characterized in that** in step c), after overetching of the first layer, the upper face of the first semiconductor layer is masked (17k) before carrying out the first implantation of the drain and source zones of the isolated gate field effect transistor.

27. Method according to Claim 26, **characterized in that** the width of the isolating lateral regions of the component is substantially identical to the width of the isolating lateral regions of the isolated gate field effect transistor.
